(19) Europäisches Patentamt
European Patent Office
Office européen des brevets

(11) **EP 3 664 132 A1**

(12) **EUROPEAN PATENT APPLICATION**
published in accordance with Art. 153(4) EPC

(43) Date of publication:
**10.06.2020 Bulletin 2020/24**

(21) Application number: **18841729.9**

(22) Date of filing: **01.08.2018**

(51) Int Cl.:
**H01L 23/36** (2006.01)     **H01L 23/40** (2006.01)

(86) International application number:
**PCT/JP2018/028835**

(87) International publication number:
**WO 2019/026952 (07.02.2019 Gazette 2019/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **02.08.2017   JP 2017149843**

(71) Applicant: **Mitsubishi Materials Corporation
Chiyoda-ku
Tokyo 100-8117 (JP)**

(72) Inventors:
• **WATANABE, Kotaro**
  **Naka-shi**
  **Ibaraki 311-0102 (JP)**
• **SAIWAI, Toshihiko**
  **Naka-shi**
  **Ibaraki 311-0102 (JP)**

(74) Representative: **Gille Hrabal
Brucknerstrasse 20
40593 Düsseldorf (DE)**

(54) **HEATSINK**

(57)     The purpose of the present invention is to improve the heat exchange performance of a heatsink. The heatsink includes: a substrate portion; a plurality of plate-like fin portions which rise integrally from a surface of the substrate portion and are arranged mutually in parallel, forming groove portions therebetween; and a porous body portion comprising at least one porous body with which the groove portions between the fin portions are filled and which has a three-dimensional mesh structure. The substrate portion and the fin portions comprise a solid non-porous material of aluminum. The porous body portion comprises a sintered body of aluminum fiber. The porous body portion is joined to the fin portions and the substrate portion via a sintered joint portion.

[FIG. 1]

EP 3 664 132 A1

**Description**

BACKGROUND OF THE INVENTION

The present invention relates to a heatsink used for radiating heat.

Priority is claimed on Japanese patent Application No. 2017-149843, filed August 2, 2017, the content of which is incorporated herein by reference.

Background Art

In electronic devices generating heat such as power modules or the like on which semiconductor elements such as power elements, a heatsink is provided for radiating the heat from heat-generating elements (the power elements) in order to work the electronic devices normally. The heatsinks broadly employed are formed from aluminum or copper having high thermal conductivity and have a structure in which a lot of fins of a plate shape, a pin shape and the like stand on one surface of a flat base board. The heatsink cools the cooled body by closely attaching the base board to a cooled body such as the power module and arranging the fins in a coolant path.

For example, in a heatsink described in Patent Document 1, plate shape fins connected by lateral ribs at a medium position in a height direction are formed on a base board by extrusion molding.

In a heatsink described in Patent Document 2, fins made of three-dimensional mesh material are bonded on a base board by brazing or the like in order to increase specific surface area. As the three-dimensional mesh material, foam metal having connected pores formed by foaming metal such as copper, nickel, stainless, aluminum and the like are exemplified.

Patent Document 3 discloses a structure in which a porous body having communicated pores is filled between fins of pin-shape or plate-shape standing on a base board. In this structure, heat is moved from the base board to the porous body by the fins of a non-porous body (a dense solid ingot) having no pores with a large area; and the heat is conducted from the porous body to the air by the porous bod: so that it is described that heat exchange performance can be improved.

Citation List

Patent Literature

Patent Document 1: Japanese Unexamined Patent Application, First Publication No. H06-244327
Patent Document 2: Japanese Unexamined Patent Application, First Publication No. 2007-184366
Patent Document 3: Japanese Unexamined Patent Application, First Publication No. 2012-9482
Patent Document 4: Japanese Unexamined Patent Application, First Publication No. 2012-14508

SUMMARY OF INVENTION

Technical Problem

The heatsink described in Patent Document 1 cannot be expected to have high thermal exchange performance because the specific surface area is small since the fin is non-porous body. The heatsink described in Patent Document 2 is feared that the brazing material bonding the fins and the base board reacts to base materials and thermal resistance increases at a bonding interface. Moreover, it is feared that the brazing material impregnates into the porous body (three-dimensional mesh material) and the specific surface area decreases: and there is a tendency for a cost to increase by the brazing material and flux which are necessary for bonding.

In the structure described in Patent Document 3, foamed aluminum (a metal porous body) having an open-cell structure is used as a porous body. The foamed metal is manufactured generally by mixing eutectic elements with metal powder and liquid phase sintering: so that the thermal conductivity decreases by the eutectic elements disperse in the foamed metal.

The inventors of the present application suggests a thermal exchanging member in Patent Document 4 that has fins formed by bonding a porous body formed by sintering and integrating aluminum fibers on a surface of a base board (a non-porous body). Thereby sintered strength of the porous body is improved and thermal conductivity is improved, so that heat can be efficiently exchanged though: further improvement of the heat exchange performance is required.

The present invention has an object to improve the heat exchange performance of the heatsink.

Solution to Problem

A heatsink according to the present invention is provided with: a base board formed of non-porous material (solid material) of aluminum; a plurality of plate like fins, formed of non-porous material of aluminum, standing integrally on a surface of the base board, and arranged with an interval mutually in parallel to form grooves; and a porous-body part including at least one porous body, formed from a sintered body of aluminum fibers having a three-dimensional mesh structure, filled in the grooves between the fins, and joined to the fins and the base board with sintered-joint portions therebetween.

In this heatsink, the porous body is filled between the fins of non-porous material, so that heat transfer is carried out in a broad area including the fins and the base board, and the porous body. Since the porous body is joined to the fins and the base board with the sintered-joint portions therebetween, heat resistance at an joint interface of the porous body to the fins and the base board is small, so that the smooth heat transfer is promoted between the porous body and the base board and the fins. The heat medium flows through vacancy in the porous body, so that the heat exchange is carried out between the surfaces of the porous body, the fins and the base board and the heat medium.

Since the heatsink has a large surface area by the porous body, the heat received at the porous body can move efficiently, and an excellent heat exchange performance can be obtained. Moreover, the porous body (the aluminum fibers) obstructs the flow of the heat medium, the flow can be disturbed (a disturbance effect), so that the effect of promoting the thermal exchange is larger in addition to the largeness of the specific surface area comparing with the heatsink formed only from non-porous material.

The porous body formed from the sintered body of the aluminum fibers has higher heat transfer coefficient than foamed metal because eutectic elements are not dispersed as in the foamed metal and skeleton is solid. The porous body can be freely controlled of the pore percentage, a size of opening diameter of the pores opening inside and the like only by changing a thickness of the aluminum fibers, a filling method and the like: flexibility of product design is high, and a desired external form can be easily made by using a molding die formed to have the desired shape.

The porous body is joined to the fins and the base board by the sintered-joint portions without brazing material, so that the pore percentage of the porous body is not decreased owing to percolation of the brazing material.

In a preferred embodiment of the heatsink of the present invention, in the porous body, in a transverse section parallel to an arrangement direction of the fins, a proportion of a number of cross sections in which an aspect ratio of a major axis diameter and a minor axis diameter is not less than 1.2 to a total number of observed cross sections of the aluminum fibers is not less than 40% and not less than 70%.

Since the proportion of the number of the cross sections of the aluminum fibers having the aspect ratio of the major axis diameter and the minor axis diameter not less than 1.2 in the transverse cross section of the porous body is not less than 40%, it is possible to increase surfaces opposing the flowing direction of the heat medium (a longitudinal direction of the fins), i.e., surfaces disturbing the flow of the heat medium. Thereby the disturbance effect disturbing the flow of the heat medium can be generated in the porous medium, the heat exchange between the porous body and the heat medium can be furthermore promoted. Moreover, it is more preferable that the proportion of the numbers of the cross sections of the aluminum fibers having the aspect ratio of the major axis diameter and the minor axis diameter not less than 1.2 be not less than 50% and not more than 60%: furthermore preferably, not less than 52% and not more than 58%.

If the proportion of the numbers of the cross section of the aluminum fibers having the aspect ratio of the major axis diameter and the minor axis diameter not less than 1.2 is less than 40% in the transverse cross section of the porous body, there are few aluminum fibers contributing to the disturbance effect so it is difficult to promote the effect disturbing the heat medium, accordingly, the heat exchange performance may be deteriorated. In contrast with that, if the proportion of the number of the cross sections of the aluminum fibers having the aspect ratio of the major axis diameter and the minor axis diameter is not less than 1.2 is more than 70%, a flow resistance of the heat medium increases and the pressure loss is too large.

In the heatsink of the present invention, as described above, since the sintered body of the aluminum fibers is used as the porous body, it is easy to make a direction of the aluminum fibers even or uneven intendedly: accordingly, it is possible to easily control the proportion of the number of the cross section of the aluminum fibers having the aspect ratio of the major axis diameter and the minor axis diameter in the transverse cross section is not less than 1.2.

Moreover, since it is possible to easily control the direction of the aluminum fibers, by arranging many aluminum fibers perpendicular to the longitudinal direction of the fins, there are few interfaces between the aluminum fibers which are the thermal resistance in a heat transfer path along a thickness direction of the porous body (an arranging direction of the fins) so that the heat transfer between the fins and the heat medium can be promoted; in contrast with that, by arranging many aluminum fibers parallel to the longitudinal direction of the fins, it is possible to reduce the pressure loss when the heat medium passes through inside the porous body.

For example, since a direction of a skeleton of the foam metal is isotropic in general, foamed metal cannot be promote the disturbance effect or reduce the pressure loss by changing the skeleton of the porous body intendedly as in the present invention.

In a preferred embodiment of the heatsink of the present invention, a vacant proportion that is a percentage of a vacant volume excluding metal portions of the fins and the porous-body part to a total volume obtained by a product of a height of the fins and a plane area of regions through which heat medium flows on the surface of the base board be not less than 40% and not more than 70%. The vacant proportion is more preferably not less than 45% and not more than 65%; furthermore preferably, not less than 50% and not more than 60%.

If the vacant proportion is less than 40%, the pressure loss to the flow of the heat medium is large. Meanwhile, if the vacant proportion is more than 70%, the heat exchange performance (the heat transfer coefficient) is low. Accordingly, since the vacant proportion is not less than 40% and not more than 70%, it is possible to improve the heat exchange performance and reduce the pressure loss.

In a preferred embodiment of the heatsink of the present invention, a specific surface area per a unit volume in a whole of the fins and the porous-body part be not less than $1.0 \times 10^3$ [m$^2$/m$^3$] and not more than $10.0 \times 10^3$ [m$^2$/m$^3$]. More preferably, the specific surface area be not less than $2 \times 10^3$ [m$^2$/m$^3$] and not more than $9 \times 10^3$ [m$^2$/m$^3$]: furthermore preferably, not less than $4 \times 10^3$ [m$^2$/m$^3$] and not more than $7 \times 10^3$ [m$^2$/m$^3$].

If the specific surface area of the whole of the fins and the porous body (the total surface area of the fins + the total surface area of the porous body)/(the volume of the fins + a bulk of the porous body) is less than $1.0 \times 10^3$ [m$^2$/m$^3$], the heat exchange area to the heat medium is small, the heat transfer coefficient of the heatsink is deteriorated, and the heat exchange performance may be deteriorated. In contrast with that, the specific surface area exceeds $10.0 \times 10^3$ [m$^2$/m$^3$], the pressure loss is large. Accordingly, since the specific surface area of the whole of the fins and the porous body is not less than $1.0 \times 10^3$ [m$^2$/m$^3$] and not more than $10.0 \times 10^3$ [m$^2$/m$^3$], it is possible to improve the heat exchange performance and reduce the pressure loss low.

In a preferred embodiment of the heatsink of the present invention, it is preferable that a longitudinal-section fiber density D1 [%] which is a percentage of a cross-sectional area of the aluminum fibers to an area of the grooves in a longitudinal cross section parallel to the surface of the base board be not less than 10% and not more than 40%; and a transverse-section fiber density D2 [%] which is a percentage of a cross-sectional area of the aluminum fibers to an area of the grooves in a transverse cross section parallel to an arrangement direction of the fins perpendicular to the longitudinal cross section be not less than 10% and not more than 40%. The longitudinal-section fiber density and the transverse-section fiber density are more preferably not less than 15% and not more than 35%; furthermore preferably, not less than 20% and not more than 30%.

If the longitudinal-section fiber density D1 and the transverse-section fiber density D2 are less than 10%, the heat exchange area to the heat medium is small, the heat transfer coefficient is deteriorated, and the heat exchange performance may be deteriorated. Meanwhile, if the longitudinal-section fiber density D1 and the transverse-section fiber density D2 exceed 40%, the pressure loss is large. Accordingly, since both the longitudinal-section fiber density D1 and the transverse-section fiber density D2 are not less than 10% and not more than 40%, it is possible to improve the heat exchange performance and reduce the pressure loss low.

In a preferred embodiment of the heatsink of the present invention, it is preferable that outer fins that are arranged at outermost side in the arrangement direction among the fins be arranged inside side edges of the base board; and the porous body be joined on outer side surfaces of the outer fins and the surface of the base board at outer part than the outer fins.

Not only filling the porous body in the grooves between the fins, but also joining the porous body to the outer side surfaces of the outer fins that are arranged at the outermost side in the arrangement direction among the fins arranged mutually in parallel and the surfaces of the base board at the outer part than the outer fins, it is possible to form the heatsink from the porous body having larger surface area comparing to a case in which the outer fins are arranged on both side edges of the base board. Accordingly, the heat received at the porous body can be transferred to the heat medium efficiently, and the heat exchange performance can be further improved.

Advantageous Effects of Invention

According to the present invention, it is possible to promote the disturbance effect of disturbing the flow of the heat medium, so that the heat exchange performance of the heatsink can be improved.

BRIEF DESCRIPTION OF DRAWINGS

[FIG. 1] It is a perspective view showing a heatsink according to one embodiment of the present invention.

[FIG. 2] It is an enlarged plan view showing a part of the heatsink shown in FIG. 1.

[FIG. 3] It is an enlarged side view showing a part of the heatsink shown in FIG. 1.

[FIG. 4] It is a photograph showing an external appearance of the heatsink shown in FIG. 1.

[FIG. 5] It is a photograph showing a cross section of a principal part of the heatsink shown in FIG. 4.

[FIG. 6] It is a photograph showing a cross section of a principal part of a porous body according to another embodiment.

[FIG. 7A] It is a side view showing a state while the heatsink in FIG. 1 is manufactured.

[FIG. 7B] It is a side view showing a state while the heatsink in FIG. 1 is manufactured.

[FIG. 8] It is a perspective view showing a plate-fin type heatsink in a comparative example.

[FIG. 9] It is a perspective view showing a plate-fin type heatsink in a comparative example.

DESCRIPTION OF EMBODIMENTS

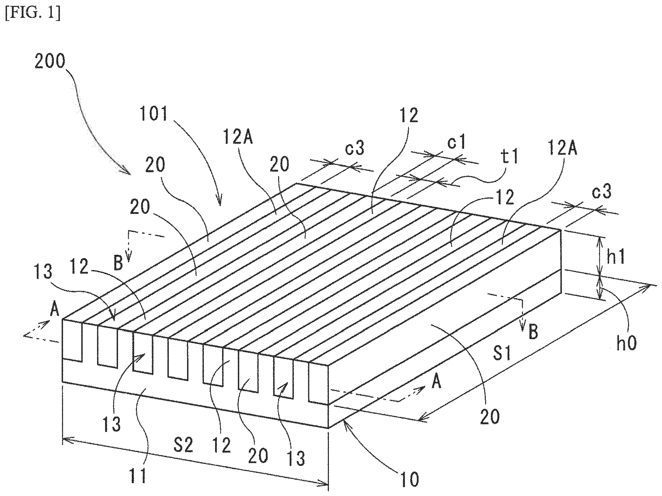

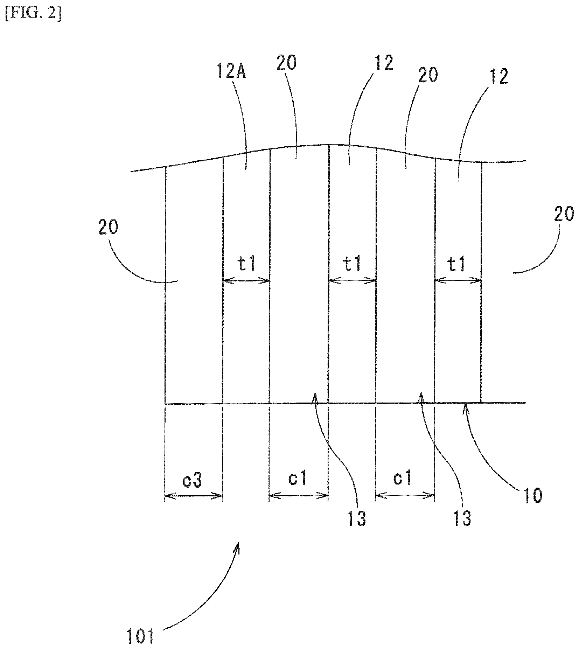

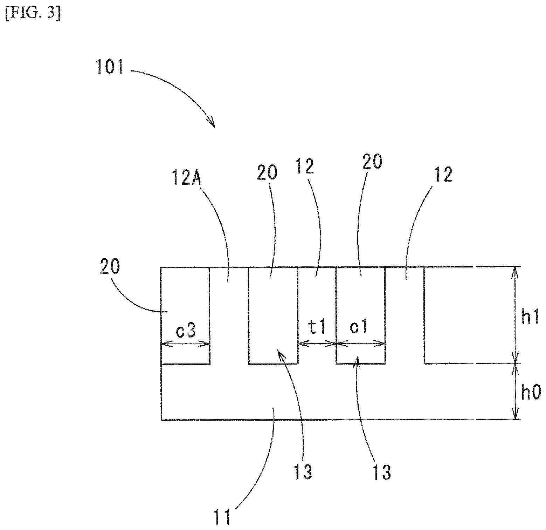

Below, embodiments of the present invention will be explained. A heatsink 101 showing one embodiment of the present invention is provided with: a base board 11 having a flat board shape; a plurality (seven in this embodiment) of plate-like fins 12 standing on a surface (one surface) of the base board 11 and arranged with an interval mutually in parallel; and a porous-body part 200 formed from one or more porous bodies 20 having a three-dimensional mesh structure and filled in grooves 13 formed between the fins 12, as shown in FIG. 1 to FIG. 4.

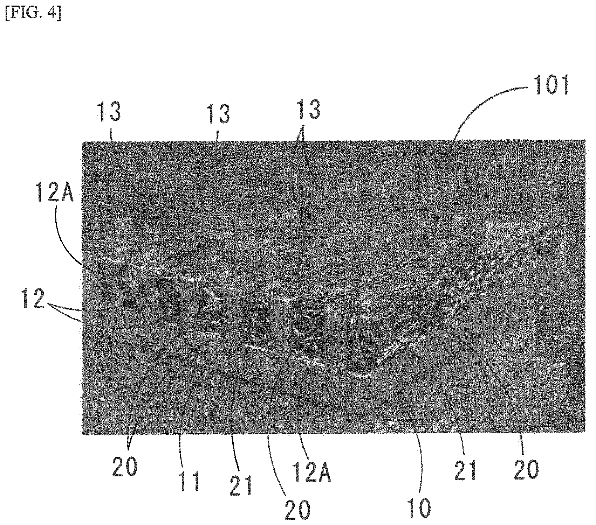

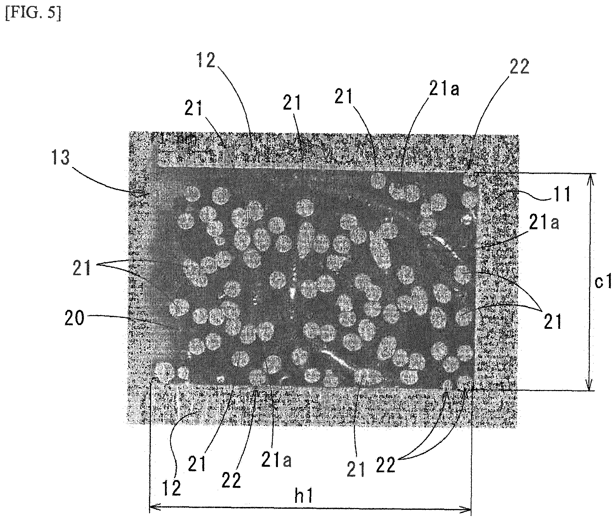

The base board 11 and the fins 12 are formed as an aluminum-formed body 10 integrally from non-porous material (solid material) of aluminum (including aluminum alloy). The porous bodies 20 are, as shown in FIG. 4 and FIG. 5, formed as sintered bodies of aluminum fibers 21 made of aluminum of the same material as that of the base board 11 and the fins 12. The porous bodies 20 are bonded on surfaces of the base board 11 and the fins 12 by sintering: sintered-joint portions 22 are formed between the surfaces of the porous bodies and the surfaces of the base board 11 and the fins 12.

For example, as shown in FIG. 1 to FIG. 3, the base board has a flat rectangle board shape; the fins 12 are provided to stand on the surface of the base board 11 with a prescribed height $h_1$ and a prescribed thickness $t_1$. In a sample shown in FIG. 1, the fins 12 are provided along entire length of a longitudinal direction of the base board 11 in a surface direction parallel to the surface of the base board 11, and arranged parallel to each other with a prescribed interval $c_1$ in a transverse direction of the base board 11. Thereby the grooves 13 with a width $c_1$ are formed between the fins 12. Among these fins 12, outer fins 12A arranged at both outermost sides are arranged at the inside of both edges of the base board 11.

Here, the "longitudinal direction" in the heatsink 101 or the base board 11 means a direction along a longitudinal dimension $S_1$ of the base board shown in FIG. 1, in other words, a length direction of fins 12 or a length direction of the porous bodies 20: the "transverse direction" of the heatsink 101 or the base board 11 means a direction along a transverse dimension $S_2$ of the base board 11 shown in FIG. 1, in other words, an arrangement direction (a thickness direction) of the fins 12 or a thickness direction of the porous bodies 20.

The porous bodies 20 are filled in the grooves 13 between the fins 12. The porous bodies 20 are formed along the length direction of the fins 12 so as to fill gaps between the fins 12, and as shown in FIG. 5, joined to the fins 12 and the base board 11 with the sintered-joint portions 22. The porous bodies 20 are arranged also at outer parts than the outer fins 12A, on the surface of the base board 11 along both the edge of the base board 11; and joined to outer side surfaces of the outer fins 12A and the surface of the base board 11 with the sintered-joint portions 22.

The porous bodies 20 are formed from a sintered body of an aggregate of a plurality (e.g., 20 to 4000 per 1 $cm^3$) of the aluminum fibers 21. The aluminum fibers 21 can be used having a thickness (an outer diameter, a fiber diameter) "d" 20 $\mu m$ to 3000 $\mu m$ inclusive and a length 0.2 mm to 50 mm inclusive.

The porous bodies 20 shown in FIG. 4 and FIG. 5 are formed from the aluminum fibers 21 having the fiber diameter "d" is 0.3 mm. In the porous bodies 20 as shown in FIG. 4 and FIG. 5, the three-dimensional mesh structure is formed by bending and piling the aluminum fibers 21 to have contact points 21a, and sintering them so that the aluminum fibers 21 are mutually joined at the contact points 21a.

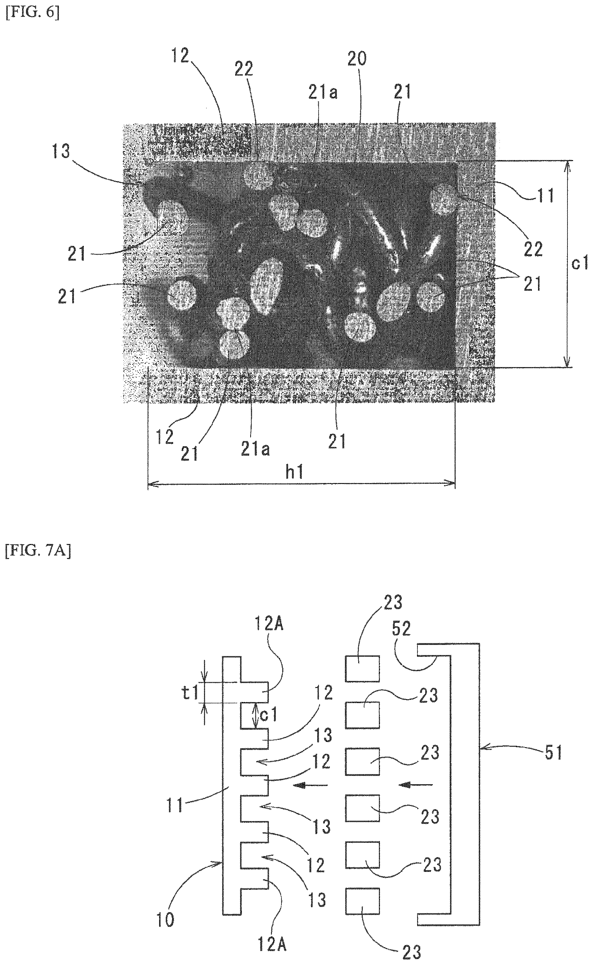

FIG. 6 shows an observation image of the porous body 20 in another embodiment at a transverse cross section parallel to an arrangement direction of the fins 12. The porous body 20 shown in FIG. 6 is formed from a sintered body of the aluminum fibers 21 having a fiber diameter "d" of 0.5 mm.

In the porous body 20, as shown in FIG. 5 and FIG. 6, the aluminum fibers 21 that are observed at the transverse cross section parallel to the arrangement direction of the fins 12 are observed as a circle section if the fibers are parallel to the length direction of the fins 12. If the fibers are inclined to the length direction of the fins 12, they are observed as an oval cross section. It is formed so that a proportion of a number of the relatively oval cross sections (in which an aspect ratio of a major axis diameter and a minor axis diameter is not less than 1.2) of the aluminum fibers 21 in a total number of the cross sections of the aluminum fibers 21 is 40% to 70% inclusive (hereinafter, "an oval fiber proportion"). Here, the "major axis diameter" is a longest (largest) dimension in the cross section of the aluminum fiber 21: and the "minor axis diameter" is a dimension perpendicular to the major axis.

As described above, by forming the oval fiber proportion in the transverse cross section of the porous body 20 to be not less than 40%, it is possible to increase surfaces against a flow of heat medium, i.e., surfaces disturbing the flow of the heat medium. Thereby a disturbance effect of disturbing the flow of the heat medium in the porous body 20 can be easily generated.

If the oval fiber proportion in the transverse cross section of the porous body 20 is less than 40%, since the less aluminum fibers 21 are difficult to promote the disturbance effect, so that the heat exchange performance is deteriorated. In contrast, if the oval fiber proportion is more than 70%, flow resistance the heat medium is disturbed by the porous body 20 and increased, and pressure loss is excessively large. The oval fiber proportion is more preferably 45% to 65% inclusive, furthermore preferably 50% to 60% inclusive.

The aspect ratio of the major axis diameter and the minor axis diameter of the aluminum fibers 21 in the transverse cross section of the porous body 20 can be easily modified by changing a thickness (the fiber diameter "d") of the aluminum fibers 21 or a method of filling into a mold. Specifically, because it is easy to make a direction of the aluminum fiber 21 even or uneven intendedly, the oval fiber proportion in the transverse cross section of the porous body 20 can be easily controlled. It is possible to control a magnitude of a pore proportion (a volume proportion of vacant portions, excluding solid parts of the aluminum fibers 21, in inner spaces of the grooves 13 in which the porous bodies 20 are filled) of the porous bodies 20 and a dimension of an open diameter of pores opening inside the porous bodies 20. It is also easy and possible to form the porous bodies 20 into a desired outer shape by using a forming mold having a desired shape.

Since it is easy to control the direction of the aluminum fibers 21 when manufacturing the porous bodies 20 as described above, it is also possible to arrange more aluminum fibers 21 vertical to the length direction of the fins 12 (i.e., parallel to the thickness direction of the fins 12). In this case, interfaces between the aluminum fibers 21 being the thermal resistance in a heat transfer path along the thickness direction of the porous bodies 20 (the thickness direction of the fins 12) are small, so it is possible to promote the heat transfer between the fins 12 and the heat medium. Moreover, the pressure loss while the heat medium passing through the inside of the porous bodies 20 can be reduced by arranging more aluminum fibers 21 in parallel to the length direction of the fins 12. In addition, foamed metal cannot promote the disturbance effect or reduce the pressure loss by changing a skeleton intendedly as in the porous bodies 20, since a direction of a skeleton is isotropic in general.

In the heatsink 101, a ratio of a vacant volume Vp in a total volume V is 40% to 70% inclusive (hereinafter it is denoted as a vacant proportion Vp/V); where the total volume V is obtained by a product of a plane area including the porous bodies 20 and the fins 12 and the height h1 of the fins 12, and the space volume Vp is obtained by subtracting aluminum portions (the solid portion) of the fins 12 and the porous bodies 20 from the total volume V. The vacant proportion Vp/V is more preferably 45% to 65% inclusive, furthermore preferably 50% to 60% inclusive.

The total volume V for calculating the vacant proportion Vp/V can be obtained by a product of the plane area (S1 × S2) of the entire base board 11 and the height h1 of the fins 12.

In a case in which "n" numbers of the fins 12 with the thickness t1 [mm] × the height h1 [mm] are provided on the base board 11 with the longitudinal dimension S1 [mm] × the lateral dimension S2 along an entire length thereof, the total volume V [mm$^3$] is V = S1 × S2 × h1. However, a relation S2 = t1 × n + c1 × (n-1) + c3 ×2 is satisfied. In addition, the respective inner porous bodies 20 have the width c1 [mm], and outsides of the respective outer fins 12A have a width c3 [mm].

The pore proportion X of the porous bodies 20 is a volume proportion of vacancy portions in the space in the grooves 13 stuffed with the porous bodies 20, excluding the portions of the aluminum fibers 21 (the solid portions). The vacant volume Vp [mm$^3$] is:

$$Vp = [V - t1 + \{2 \times c3 + (n-1) \times c1\} \times (1 - X/100)] \times S1 \times h1$$

when the heatsink 101 is formed by joining the porous bodies 20 with the pore proportion X % in the grooves 13 with the width c1 [mm] and a depth h1 [mm] and to the outside of the outer fins 12A (the width c3 [mm]). The vacant proportion is obtained as Vp/V.

In the heatsink 101, a specific surface area of a whole of the fins 12 and the porous bodies 20 per volume (a total surface area of the fins 12 + the total surface area of the porous bodies 20)/(a volume of the fins 12 + a bulk of the porous bodies 20) is set to not less than $1.0 \times 10^3$ [m$^2$/m$^3$] and not more than $10.0 \times 10^3$ [m$^2$/m$^3$]. The specific surface area is more preferably not less than $2.0 \times 10^3$ [m$^2$/m$^3$] and not more than $9.0 \times 10^3$ [m$^2$/m$^3$], and furthermore preferably not less than $3.0 \times 10^3$ [m$^2$/m$^3$] and not more than $8.0 \times 10^3$ [m$^2$/m$^3$].

The porous bodies 20 has a longitudinal-section fiber density D1 is 10% to 40% inclusive and a transverse-section fiber density D2 is 10% to 40% inclusive; where the longitudinal-section fiber density D1 [%] is a proportion of a sectional area of the aluminum fibers 21 in an area of the grooves 13 (an area between the fins 12) in a longitudinal section parallel to the surface of the base board 11 (a cross section along the line A-A in FIG. 1); and the transverse-section fiber density D2 [%] is a proportion of the aluminum fibers 21 in a sectional area of any one of the grooves 13 (the area between the fins 12) in a transverse section (a cross section along the line B-B in FIG. 1) parallel to the thickness direction of the fins 12, perpendicular to the longitudinal section.

It is more preferable that the longitudinal-section fiber density and the transverse-section fiber density be 15[%] to 35 [%] inclusive; and furthermore preferably, 20 [%] to 30 [%] inclusive.

The fiber densities are area proportion of the aluminum fibers 21 in the respective cross sections as described above. Specifically, the transverse-section fiber density D2 is obtained by calculating a proportion of a sectional area of the aluminum fibers 21 in a whole area in the transverse cross section of the porous bodies 20 shown in FIG. 5 (the cross section taken along the B-B line shown in FIG. 1): the whole area is obtained by the product ($h1 \times c1$) of the height $h1$ of the fins 12 and the interval $c1$ between the fins 12 (the width of the grooves 13).

Although the illustration is omitted, the longitudinal-section fiber density D1 is obtained by calculating a proportion of a section area of the aluminum fibers 21 in a whole area obtained by a product ($S1 \times c1$) of the length of the fins 12 (the longitudinal dimension $S1$ of the base board 11) and the interval $c1$ between the fins 12, in the longitudinal cross section of the porous bodies 20 (a cross section taken along the line A-A shown in FIG. 1).

The higher the fiber densities are, the more the flow resistance of the heat medium, so that the pressure loss is tend to increase though; meanwhile, the disturbance effect is easy to occur and the heat transfer performance is easy to be improved. If the longitudinal-section fiber density D1 and the transverse-section fiber density D2 are less than 10%, a heat exchange area to the heat medium is decreased since the pore proportion of the porous bodies 20 is increased. Accordingly, the thermal conductivity is deteriorated, and there is a fear that the heat transfer coefficient of the heatsink 101 may be deteriorated. If the longitudinal-section fiber density D1 and the transverse-section fiber density D2 is more than 40%, the flow resistance of the heat medium is increased and the pressure loss is increased.

From this point of view, it is desirable that the longitudinal-section fiber density D1 and the transverse-section fiber density D2 be 15% to 35% inclusive. The pore proportion X of the porous bodies 20 is a vacant volume which excludes the aluminum fibers 21 (the solid portions) in the whole volume obtained by a product of the plane area (the longitudinal dimension $S1 \times$ the interval $c1$) of a region through which the heat medium flows in the grooves 13 and the height $h1$ of the fins 12.

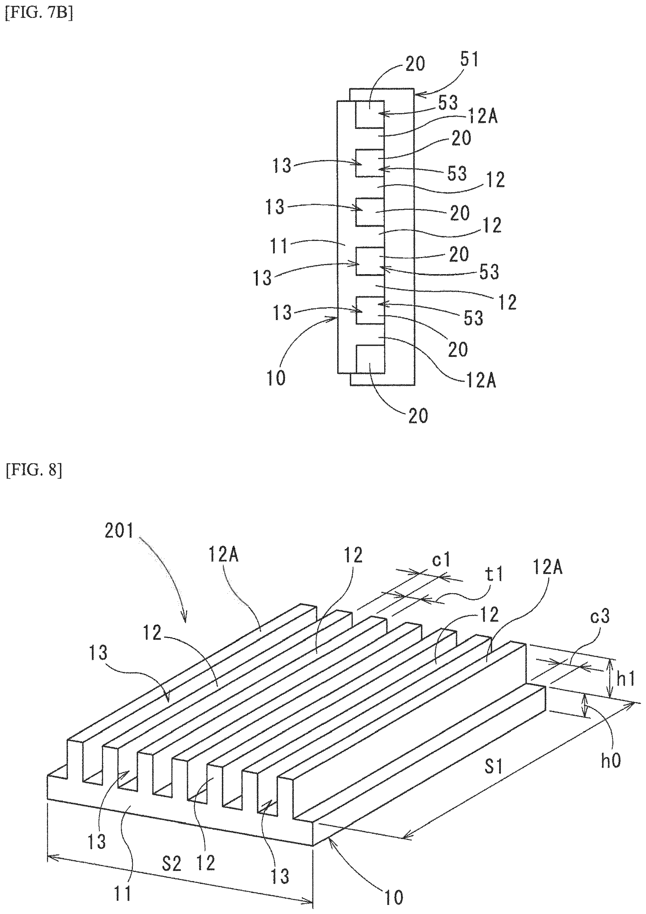

In a case of manufacturing the heatsink 101 structured as above, the aluminum-formed body 10 of non-porous material is formed to have the base board 11 and the fins 12 integrally by extrusion molding of aluminum for example, and the porous bodies 20 are joined in the grooves 13 between the fins 12 by using a mold 51 shown in FIGS. 7A and 7B.

The mold 51 is made of material such as carbon and the like, which does not easily react with aluminum of the aluminum-formed body 10 and the porous bodies 20, and as shown in FIG. 7A, formed as a plate shape having a rectangular hollow part 52 on one surface, to put the fins 12 in. As shown in FIG. 7B, by piling the mold 51 on the base board 11 so as to mutually face, spaces 53 for forming the porous bodies 20 are formed between the aluminum-formed body and the mold 51.

Aggregates 23 of the aluminum fibers 21 are arranged beforehand in the grooves 13 between the fins 12 forming the spaces 53, then the aluminum-formed body 10 and the mold 51 are piled, so that the spaces 53 are stuffed with the aggregates 23 of the aluminum fibers 21. Then, by heating them in inert atmosphere with temperature of 600°C to 660°C for 0.5 minutes to 60 minutes for example, the porous bodies 20 in which the aluminum fibers 21 are sintered at the contact points 21a to each other are formed, and the aluminum fibers 21 and the aluminum-formed body 10 (the fins 12 and the base board 11) are sintered so that the sintered-joint portions 22 are formed. Thereby obtained is the heatsink 101 in which the porous bodies 20 and the aluminum-formed body 10 are integrally joined with the sintered-joint portions 22.

In the heatsink 101 structured as above, the porous bodies 20 are respectively filled in the grooves 13 between the fins 12 of the aluminum-formed body 10, so that the heat transfers through a broad area of the fins 12 and the base board 11 (the aluminum-formed body 10). Moreover, since the porous bodies 20 are joined on the fins 12 and the base board 11 with the sintered-joint portions 22, the heat resistance is small at the joint interfaces of the porous bodies 20 and the fins 12 and the base board 11, so that the heat can be smoothly transferred between the base board 11 and the fins 12 and the porous bodies 20.

The heat medium flows through the vacant spaces in the porous bodies 20, so that the heat transmission is carried out between the heat medium and the respective surfaces of the porous bodies 20, the fins 12 and the base board 11. In this case, since the large surface area is formed in the heatsink 101 by the porous bodies 20, the heat received by the porous bodies 20 moves efficiently to the heat medium, so that an excellent heat transmission performance can be obtained. Moreover, the porous bodies 20 obstruct the flows of the heat medium, so that the flows of the heat medium can be disturbed. Accordingly, in comparison with a heatsink which is made only from non-porous material, there is an effect of promoting the heat transmission in addition to an effect of the large specific surface area.

As described above, since the porous bodies 20 are formed from the sintered bodies of the aluminum fibers 21, less eutectic elements which deteriorate the thermal conductivity are dispersed unlike in foamed metal, so that the higher thermal conductivity can be obtained than the foamed metal. Moreover, the porous bodies 20 has high flexibility of product design because magnitude of the pore percentage, opening size of the pores opening inside and the like can be freely modified only by changing thickness or the filling method of the aluminum fibers 21. Furthermore, the porous bodies can be easily formed into a desired outer shape by using a forming die formed to have the desired shape.

The porous bodies 20 are joined to the fins 12 and the base board 11 by the sintered-joint portions 22 and brazing material is not used, the pore proportion of the porous bodies 20 is not decreased by permeation of the brazing material.

In the heatsink 101 of the present embodiment, the oval fiber proportion at the transverse cross section of the porous bodies 20 is 40% to 70% inclusive, so increased are the surfaces against the direction of the flow of the heat medium (the length direction of the fins 12), in other words, the surfaces disturbing the flow of the heat medium. Thereby the disturbance effect of disturbing the flow of the heat medium is easily obtained in the porous bodies 20, and the heat exchange with respect to the heat medium is further promoted.

Moreover, as described above, in the aluminum fibers 21 structuring the pore bodies 20, it is easy to make the direction of the fibers even or uneven intendedly, so that the oval fiber proportion in the transverse cross section of the porous bodies 20 can be easily controlled.

Moreover, in the heatsink 101 of the present embodiment, since the vacant proportion is set to 40% to 70% inclusive as described above, it is possible to improve the heat exchange performance with reducing the increase of the pressure loss. If the vacant proportion is less than 40%, the pressure loss is large with respect to the flow of the heat medium: if the vacant proportion is more than 70%, the heat exchange performance is deteriorated.

The specific surface area of the fins 12 and the porous bodies 20 in total is set to not less than $1.0 \times 10^3$ [m²/m³] and not more than $10.0 \times 10^3$ [m²/m³], so that there are effects of improving the heat exchange performance and the reduction of the pressure loss. If the specific surface area is less than $1.0 \times 10^3$ [m²/m³], the heat exchange performance is deteriorated resulting from reduction of a heat exchange area: if it is more than $10 \times 10^3$ [m²/m³], an increase of the pressure loss is incurred.

Moreover, as described above, since both the longitudinal-section fiber density D1 and the transverse-section fiber density D2 are 10% to 40%, the heat exchange performance can be improved and the pressure loss can be reduced low. If the longitudinal-section fiber density D1 and the transverse-section fiber density D2 are less than 10%, the heat exchange area with the heat medium is reduced, so that the heat transfer coefficient is reduced and the heat exchange performance may be deteriorated. If the longitudinal-section fiber density D1 and the transverse-section fiber density D2 are more than 40%, the pressure loss is increased.

As examples of the present invention, the heatsinks 101 (Sample Nos. 1 to 8) having the plate like fins 12 were made as in the above-mentioned embodiment shown in FIG. 1. The base board 11 was a longitudinal dimension S1: 55 mm × a transverse dimension S2: 38 mm, a board thickness h: 0.4 mm, the fins 12 were made along the entire length of the base board 11. Six pieces of the fins 12 were made, and a height h1 of the fins 12 was 6 mm. The fins 12 were arranged inside the side edges of the base board 11. A thickness t1 of the fins 12 was 2.3 mm and an interval c1 of the fins 12 was 4 mm. An interval c3 between an outer side surface of the outer fins 12A and the side edges of the base board was 2.1 mm.

As a Comparative Example (Sample No. 9), a heatsink 201 in which a porous body was not provided but made only of the aluminum-formed body 10 having the base board 11 and the plate like fins 12 was made as shown in FIG. 8. The heatsink 201 was made at the same dimensions as that of the aluminum-formed body 10 of Examples (Sample Nos. 1 to 8) of the present invention.

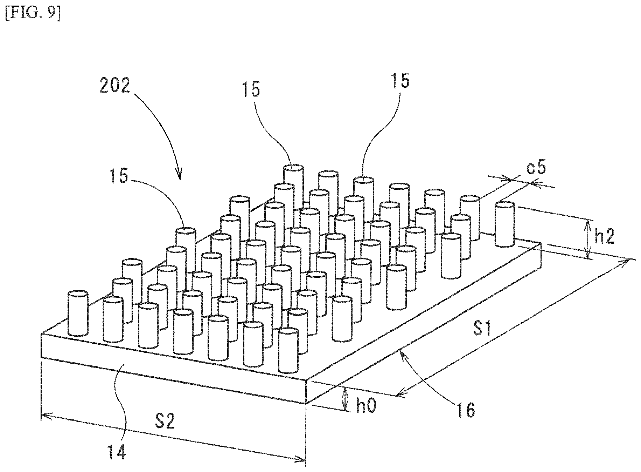

As a Comparative Example (Sample No. 10), a pin-fin type heatsink 202 having pin like fins 15 was made as shown in FIG. 9. The heatsink 202 also formed only from an aluminum-formed body 16 structure from the fins 15 and a base board 14 was formed, in which a porous body was not provided. The base board 14 was formed at the same dimension as that of the base board 11 of the aluminum-formed body in Examples (Sample Nos. 1 to 8) of the present invention. The fins 15 had a diameter: 2.3 mm, a height h2: 6 mm and a detached distance c5: 6.8 mm, and were arranged so that adjacent fins form vertexes of an equilateral triangle. The height h2 of the fins 15 is the same as the height h1 of the plate like fins 12 of the aluminum-formed body 10 in Examples (Sample Nos. 1 to 8).

The aluminum formed bodies 10 and 16 and the porous body 20 were made by using A1050 (pure aluminum of 99.50% or more of A1 component) as material. The porous body 20 was made with various factors (a fiber diameter, a pore proportion, a fiber density and the like) shown in Table 1 and Table 2.

The pore proportion X of the porous body 20 was calculated from a calculation formula of: the pore proportion $X = \{c1 \times h1 \times S1 - (m/p)\} / (c1 \times h1 \times S1)$, where fiber weight is "m" [g] and specific fiber gravity is "p" [g/cm³] of aluminum fibers 21 in the porous body 20 filled in one of the grooves 13.

Vacant proportions of the respective heatsinks were calculated based on the pore proportion X of the porous body 20, where the heat exchange was performed between the heat medium and a whole surface of the base board 11 and 14 on which the fins 12 and 15 were stand (the total volume $V = S1 \times S2 \times h1$ or $V = S1 \times S2 \times h2$).

The longitudinal-section fiber density D1 and the transverse-section fiber density D2 of the porous body 20 were calculated as follows. Colorless and transparent resin (specifically, epoxy resin) was filled in the grooves 13 in which the porous bodies 20 are fixed, i.e., between the fins 12 (the space in the porous bodies 20): longitudinal sectional surfaces of the porous bodies 20 cut in a longitudinal direction at a position of 4 mm from a tip of the fins 12 were polished; and transverse sectional surfaces of the porous bodies 20 cut in the transverse direction at three positions divided into four in the longitudinal direction were polished: and images of the sectional surfaces were taken by a microscope. With respect to the images, by binarizing the aluminum fivers 21 and the space in the porous bodies 20 using an image analysis software (WinROOF made by Mitani Corporation), fiber density [%] was measured.

A total number of cross sections of the aluminum fibers 21 was counted observed in the images of the transverse section on the three positions of the porous bodies 20; and a major axis diameter and a minor axis diameter of the cross sections of the aluminum fibers 21 were measured by a scale. An aspect ratio of the major axis diameter and the minor axis diameter of the aluminum fibers 21 was calculated, a number of the relatively oval cross sections of the aluminum fibers 21 with the aspect ratio of not less than 1.2 was counted; and the ratio (an oval fiber proportion) was obtained.

With respect to the aluminum fibers 21 in which the aspect ratio of the major axis diameter and the minor axis diameter is less than 1.05, a mean value of the major axis diameter of the aluminum fibers 21 was obtained to be the fiber diameter "d" (a thickness) of the aluminum fibers 21 structuring the porous bodies 20.

The specific surface area of the whole of the fins 12 and the porous bodies 20 of the heatsink 101, the specific surface area of the fins 12 of the heatsink 201, and the specific surface area of the fins 15 of the heatsink 202 were respectively calculated from the following formulas.

The surface area of the fins 12

$$A1 = S1 \times \{(12 \times h1) + (5 \times c1) + (2 \times c3)\}$$

The surface area of the fins 15

$$A2 = S1 \times S2 - \pi \times (2.3 \times 10^{-3})^2 \times N + \pi \times (2.3 \times 10^{-3}) h2 \times N$$

(here, "N" is a number of pins)

The surface area of the porous bodies 20

$$A3 = 4 \times [\{(5 \times c1) + (2 \times c3)\} \times h1 \times S1 \times \{1 - (X/100)\}]/d$$

The heatsink 101 (Sample Nos. 1 to 8)

$$\text{Volume } V1 = S1 \times S2 \times h1$$

Specific surface area of the whole of the fins 12 and the porous bodies 20 (A1 + A3)/V1

The heatsink 201 (Sample No. 9)

$$\text{Volume } V1 = S1 \times S2 \times h1$$

Specific surface area of the fins 12 A1/V1

The heatsink 202 (Sample No. 10)

$$\text{Volume } V2 = S1 \times S2 \times h2$$

Specific surface area of the fins 15 A2/V2

The pressure loss was measured as follows using a coolability measuring device in which the heat medium (water) flows one direction. The heatsinks 101, 201 and 202 were fitted to the measuring device, the heat medium of 30°C was flown to the fins 12 and 15 at a volume flow rate of 4 L/min (constant), and differential pressure before and after the heatsinks 101, 201 and 202 was measured as the pressure loss. The heat medium was flown in the longitudinal direction of the base boards 11 and 14 (a longitudinal direction of the fins 12 in a case of the plate-fin type heatsinks 101 and 201).

The heat transfer coefficients (the heat exchange performance) H of the heatsinks were measured as follows, using the coolability measuring device used in measuring the pressure loss. At center parts on the base boards 11 and 14 of the heatsinks 101, 201 and 202 (on opposite surfaces to the fins 12 and 15), soft heat radiation grease, cooled members (heat-generating elements) and heat insulation member were piled in order; the cooled members were press-joined at 50 cm·N by a pressing tool.

In a laboratory controlled at a constant temperature (30°C), the heat medium (water) of 30°C was flown at 4 L/min (constant) to the fins 12 and 15 for 5 minutes: after confirming that the temperature of the cooled members (temperature before heat generation) was steady, the cooled members generated heat for 15 minutes at electric power of 450 W, and temperature $Tb1$ at an interface of the cooled members joined on the center parts of the base boards 11 and 14 and the base boards 11 and 14 and water temperature $Tw$ were measured. Then, using the temperature $Tb1$, temperature $Tb2$ at an interface of the heat medium (water) and the base boards 11 and 14 was calculated by a formula of $Tb2 = [Tb1 - \{450 \times h0/(A \times k)\}]$. Here, "h0" is a thickness of the base boards 11 and 14; "A" is a mounting area of the cooled member to the base boards 11 and 14; and "k" is a heat transfer coefficient of A1050 (aluminum).

From a formula $H = [450/\{A \times (Tb2 - Tw)\}]$, using the calculated temperature $Tb2$, the heat transfer coefficients H of the respective heatsinks were calculated and evaluated as parameters of the heat exchange performance of the heatsinks 101, 201 and 202. That is to say, larger the heat transfer coefficient H, it can be evaluated as a heatsink having an excellent heat exchange performance.

Results of them are shown in Tables 1 to 3. Since Sample Nos. 9 and 10 are the heatsinks 201 and 202 that are formed only from the aluminum formed bodies 10 and 16 with which the porous bodies are not provided, items regarding the porous bodies in Tables 1 to 3 were denoted by "-".

[Table 1]

| Sample No. | POROUS BODY | | VACANT PROPORTION [%] | SPECIFIC SURFACE AREA $\times 10^3$[m$^2$/m$^3$] |
|---|---|---|---|---|
| | FIBER DIAMETER d [mm] | PORE PERCENTAGE X [%] | | |
| 1 | 0.2 | 75.0 | 47.8 | 5.0 |
| 2 | 0.2 | 75.0 | 47.8 | 5.0 |
| 3 | 0.2 | 75.0 | 47.8 | 5.0 |
| 4 | 0.2 | 75.0 | 47.8 | 5.0 |
| 5 | 0.2 | 82.0 | 52.2 | 3.6 |
| 6 | 0.3 | 75.0 | 47.8 | 3.3 |
| 7 | 0.3 | 82.0 | 52.2 | 2.4 |
| 8 | 0.5 | 87.0 | 55.4 | 1.0 |
| 9 | - | - | 70.0 | 0.6 |
| 10 | - | - | 63.7 | 0.4 |

[Table 2]

| Sample No. | LONGITUDINAL-SECTION FIBER DENSITY D1 [%] | TRANSVERSE-SECTION FIBER DENSITY D2 [%] |
|---|---|---|
| 1 | 29.3 | 31.6 |
| 2 | 28.3 | 32.3 |
| 3 | 29.5 | 31.8 |
| 4 | 30.5 | 32.9 |
| 5 | 17.3 | 24.1 |
| 6 | 31.8 | 30.5 |

(continued)

| Sample No. | LONGITUDINAL-SECTION FIBER DENSITY D1 [%] | TRANSVERSE-SECTION FIBER DENSITY D2 [%] |
|---|---|---|
| 7 | 19.8 | 22.1 |
| 8 | 13.7 | 18.5 |
| 9 | - | - |
| 10 | - | - |

[Table 3]

| Sample No. | OVAL FIBER PROPORTION [%] | PRESSURE LOSS [kPa] | HEAT TRANSFER COEFFICIENT H [kW/m²K] |
|---|---|---|---|
| 1 | 53.7 | 9.8 | 36.8 |
| 2 | 20.1 | 3.0 | 27.2 |
| 3 | 67.8 | 10.0 | 40.3 |
| 4 | 88.5 | 13.1 | 46.1 |
| 5 | 47.6 | 4.9 | 34.4 |
| 6 | 42.6 | 5.1 | 37.3 |
| 7 | 50.7 | 3.6 | 36.0 |
| 8 | 54.3 | 2.8 | 35.2 |
| 9 | - | 0.9 | 25.7 |
| 10 | - | 0.2 | 21.7 |

As recognized from these results, Sample Nos. 1 to 8 of Examples of the present invention having the porous bodies 20 could obtain higher heat transfer coefficient in comparison with Sample Nos 9 and 10 which were not provided with the porous body. In Sample Nos. 1 to 8 of Examples of the present invention, the vacant proportion was 40% to 70% inclusive, the specific surface area per unit volume in the whole of the fins 12 and the porous bodies 20 was $1.0 \times 10^3$ m²/m³ to $10.0 \times 10^3$ m²/m³ inclusive, and the fiver densities D1 and D2 were 10% to 40% inclusive: the heat transfer coefficient was maintained high and the pressure loss was reduced low.

Among Examples 1 to 8 of the present invention, in Sample Nos 1,3 and 5 to 8 in which the oval fiber proportion in the transverse section of the porous bodies 20 was 40% to 70% inclusive, a balance of the heat transfer coefficient and the pressure loss was especially good, so that the increase of the pressure loss was restrained, and the the high heat transfer coefficient could be maintained efficiently.

The present invention is not limited to the above-described embodiments and various modifications may be made without departing from the scope of the present invention.

For example, the porous bodies are formed in the grooves between the fins in the above embodiment though, it may be provided so as to cover also on tips of the fins. In that case, a height of fins includes a thickness of porous bodies at the tips of the fins. In the above embodiment, it was explained that the fins, the base board and the porous bodies were structured by A1050 though: it is not limited to this, other aluminum or aluminum alloys may structure them. Moreover, the fins, the base board and the porous bodies may be structured from aluminum (aluminum alloys) with different purity respectively.

Industrial Applicability

The heat exchange performance of the heatsink can be improved.

Reference Signs List

| 101, 201, 202 | Heatsink |
|---|---|
| 10, 16 | Aluminum-formed body |
| 11, 14 | Base board |
| 12, 15 | Fins |
| 12A | Outer fin |
| 13 | Groove |
| 20 | Porous body |
| 200 | Porous-body part |
| 21 | Aluminum fiber |
| 22 | Sintered-joint portion |
| 51 | Mold |

**Claims**

1. A heatsink comprising:

   a base board formed of non-porous material of aluminum;
   a plurality of plate like fins, formed of non-porous material of aluminum, standing integrally on a surface of the base board, and arranged with an interval mutually in parallel to form grooves; and
   a porous-body part including at least one porous body, formed from a sintered body of aluminum fibers having a three-dimensional mesh structure, filled in the grooves between the fins, and joined to the fins and the base board with sintered-joint portions therebetween.

2. The heatsink according to claim 1, wherein
   in the porous body, in a transverse section parallel to an arrangement direction of the fins, a proportion of a number of cross sections in which an aspect ratio of a major axis diameter and a minor axis diameter is not less than 1.2 to a total number of observed cross sections of the aluminum fibers is not less than 40% and not less than 70%.

3. The heatsink according to claim 1 or 2, wherein
   a vacant proportion that is a percentage of a vacant volume excluding metal portions of the fins and the porous-body part to a total volume obtained by a product of a height of the fins and a plane area of regions through which heat medium flows on the surface of the base board is not less than 40% and not more than 70%.

4. The heatsink according to any one of claims 1 to 3, wherein
   a specific surface area per a unit volume in a whole of the fins and the porous-body part is not less than $1.0 \times 10^3$ $[m^2/m^3]$ and not more than $10.0 \times 10^3$ $[m^2/m^3]$.

5. The heatsink according to any one of claims 1 to 4, wherein
   a longitudinal-section fiber density D1 [%] which is a percentage of a cross-sectional area of the aluminum fibers to an area of the grooves in a longitudinal cross section parallel to the surface of the base board is not less than 10% and not more than 40%; and
   a transverse-section fiber density D2 [%] which is a percentage of a cross-sectional area of the aluminum fibers to an area of the grooves in a transverse cross section parallel to an arrangement direction of the fins perpendicular to the longitudinal cross section is not less than 10% and not more than 40%.

6. The heatsink according to any one of claims 1 to 5, wherein
   outer fins that are arranged at outermost side in the arrangement direction among the fins are respectively arranged inside side edges of the base board; and
   the porous body is joined on outer side surfaces of the outer fins and the surface of the base board at outer part than the outer fins.

[FIG. 1]

[FIG. 2]

[FIG. 3]

[FIG. 4]

[FIG. 5]

[FIG. 6]

[FIG. 7A]

[FIG. 7B]

[FIG. 8]

[FIG. 9]

## INTERNATIONAL SEARCH REPORT

| International application No. |
| --- |
| PCT/JP2018/028835 |

A. CLASSIFICATION OF SUBJECT MATTER
Int.Cl. H01L23/36(2006.01)i, H01L23/40(2006.01)i

According to International Patent Classification (IPC) or to both national classification and IPC

B. FIELDS SEARCHED

Minimum documentation searched (classification system followed by classification symbols)
Int.Cl. H01L23/36, H01L23/40

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y<br>A | JP 2016-194118 A (MITSUBISHI MATERIALS CORP.) 17 November 2016, paragraphs [0003]-[0017], [0026]-[0070], fig. 1, 6 (Family: none) | 1, 3-5<br>2, 6 |
| Y<br>A | JP 2012-9482 A (NITTO KOGYO CORPORATION) 12 January 2012, paragraphs [0002]-[0021], fig. 1-2 (Family: none) | 1, 3-5<br>2, 6 |

☒ Further documents are listed in the continuation of Box C.  ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    25 September 2018 (25.09.2018) | Date of mailing of the international search report<br>    09 October 2018 (09.10.2018) |
| --- | --- |
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

International application No.

PCT/JP2018/028835

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2011-7365 A (TAISEI KOGYO CO., LTD.) 13 January 2011, paragraphs [0001], [0021]-[0023], [0064]-[0065], [0074]-[0075], fig. 2 (Family: none) | 1-6 |
| A | WO 2014/045714 A1 (NEC CORP.) 27 March 2014, specification, page 4, line 15 to page 11, line 4, fig. 1-4 & US 2015/0241096 A1, paragraphs [0027]-[0065], fig. 1-4 & EP 2899753 A1 & CN 104662656 A | 1-6 |
| A | JP 2003-37226 A (DELPHI TECHNOLOGIES, INC.) 07 February 2003, fig. 1-5 & US 2001/0045270 A1, fig. 1-3 & US 2001/0032720 A1 & WO 2001/069159 A1 & WO 2001/069160 A1 & EP 1263040 A2 | 1-6 |

Form PCT/ISA/210 (continuation of second sheet) (January 2015)

**EP 3 664 132 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017149843 A
- JP H06244327 B
- JP 2007184366 A
- JP 2012009482 A
- JP 2012014508 A